**Europäisches Patentamt**

**European Patent Office**

**Office européen des brevets**

(19)

(11) Veröffentlichungsnummer: **0 155 627 B1**

(12)

# EUROPÄISCHE PATENTSCHRIFT

(45) Veröffentlichungstag der Patentschrift:
20.07.88

(51) Int. Cl.⁴: **G 01 R 15/08, H 02 H 9/04**

(21) Anmeldenummer: **85102799.5**

(22) Anmeldetag: **12.03.85**

(54) **Shunt-Anordnung.**

(30) Priorität: **21.03.84 CH 1421/84**

(43) Veröffentlichungstag der Anmeldung:
**25.09.85 Patentblatt 85/39**

(45) Bekanntmachung des Hinweises auf die Patenterteilung:
**20.07.88 Patentblatt 88/29**

(84) Benannte Vertragsstaaten:
**AT CH DE FR LI SE**

(56) Entgegenhaltungen:
**FR-A-2 034 741**
**US-A-3 638 114**
**US-A-4 322 767**

**ELECTRICAL DESIGN NEWS, Band 16, Nr. 22, 15. November 1971, Seite 51; L. STRAHAN: "Logic-supply crowbar"**

(73) Patentinhaber: **BBC Brown Boveri AG, Haselstrasse, CH- 5401 Baden (CH)**

(72) Erfinder: **Maschek, Martin, Dipl.- Ing., Juchstrasse 10, CH- 8116 Würenlos (CH)**
Erfinder: **Mastner, Georg, Dr., Loonstrasse 5, CH- 5443 Niederrohrdorf (DE)**

## Beschreibung

Die vorliegende Erfindung bezieht sich auf eine Shunt-Anordnung gemäß dem Oberbegriff des Anspruchs 1.

Aus der US-A-3 638 114 ist eine derartige Shunt-Anordnung bekannt, bei welcher zwei bzw. drei Shunts in Reihe geschaltet sind. Ein Teil dieser Shunts wird mit einer parallelgeschalteten Überspannungsschutzschaltung vor Überlastung geschützt. Diese Überspannungsschutzschaltung ist mit Zenerdioden bestückt und ist deshalb nur mit vergleichsweise kleinen Strömen belastbar. Innerhalb eines den Spannungsnullpunkt enthaltenden Arbeitsbereichs sperrt die Überspannungsschutzschaltung. Erst wenn die an den parallel liegenden Shunts abfallende Spannung einen positiven oder einen negativen Grenzwert erreicht, wird die Überspannungsschutzschaltung ausreichend leitend. Diese Shunt-Anordnung weist nur einen Ausgang auf für alle Messbereiche, was zur Folge hat, dass bei Messignalen hoher Bandbreite die Genauigkeit der Messung leidet.

Eine Überspannungsschutzschaltung, welche ein schaltbares bidirektionales Halbleiterventil enthält, ist aus der FR-A-2 034 741 bekannt. Derartige Schaltungen sind in der Regel für vergleichsweise kleine Ströme ausgelegt und können in der Schutztechnik für Energieversorgungsanlagen nicht eingesetzt werden.

Aufgabe der Erfindung ist es, eine Shunt-Anordnung zu schaffen, welche zwei voneinander unabhängige Meßbereiche aufweist, von denen einer sich im Bereich kleiner Meßwerte durch besonders grosse Genauigkeit auszeichnet, so dass diese Anordnung insbesondere fur die Verarbeitung von Meßignalen induktiver Stromwandler geeignet ist.

Diese Aufgabe wird durch die Erfindung, wie sie in den Ansprüchen gekennzeichnet ist, gelöst.

Die Vorteile der Erfindung sind vor allem darin zu sehen, daß der von einer einzigen Quelle gelieferte Strom ohne aufwendige und in ihren Rückwirkungen oft schwer kalkulierbare Zwischenumsetzung, etwa durch Transformatoren, sowohl mit großer Dynamik bei geringerer Präzision als auch mit großer Präzision bei geringerer Dynamik umgesetzt werden kann.

Im Fall der Verarbeitung von Ausgangsströmen induktiver Stromwandler ermöglicht die erfindungsgemäße Shunt-Anordnung insbesondere die Einsparung eines zweiten, zum Schutz des empfindlichen Präzisionsshunts bei höheren Strömen sättigenden luftspaltlosen Wandlers, wie sie sonst für Meßzwecke eingesetzt werden.

Im folgenden wird die Erfindung anhand von lediglich einen Ausführungsweg darstellenden Zeichnungen näher erläutert.

Es zeigt:

Fig. 1 eine erfindungsgemäße Shunt-Anordnung gemäße einer ersten Ausführungsform,

Fig. 2 einen Teil einer erfindungsgemäßen Shunt-Anordnung gemäß einer zweiten Ausführungsform und

Fig. 3 die zeitlichen Verläufe verschiedener in erfindungsgemäßen Shunt-Anordnungen gemäß der ersten oder zweiten Ausführungsform auftretenden elektrischen Größen.

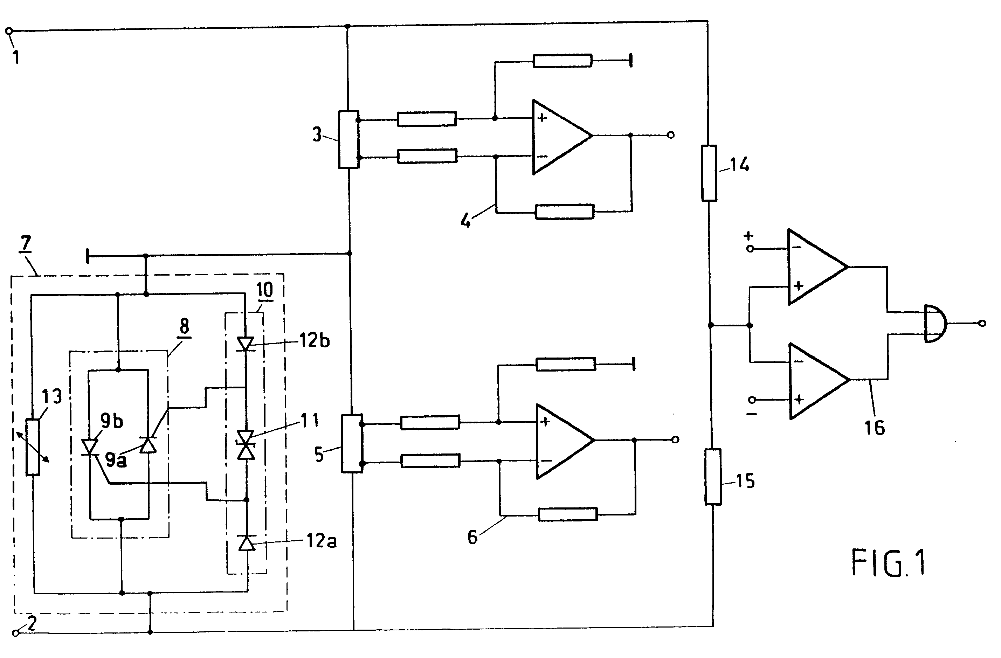

Die Shunt-Anordnung gemäß Fig. 1 enthält in ihrem grundsätzlichen Aufbau zwischen einem ersten Anschluß 1 und einem zweiten Anschluß 2 einen Leistungsshunt 3, wie sie im Handel erhältlich sind. Dem Leistungsshunt 3 ist eine mittels Kelvin-Klemmen angeschloßene erste Verstärkerschaltung 6 an sich bekannter Art nachgeschaltet.

Erfindungsgemäß ist in Reihe zum Leistungsshunt 3 ein Präzisionsshunt 5 gelegt, welcher als hochpräziser Schichtwiderstand, wie sie z. B. von der Firma VISHAY angeboten werden, realisiert sein kann und dem eine ebenfalls mittels Kelvin-Klemmen angeschloßene zweite Verstärkerschaltung 6 an sich bekannter Art nachgeschaltet ist, und parallel zu demselben eine Überspannungsschutzschaltung 7, welche sperrt, solange die über den Präzisionsshunt 5 abfallende Spannung innerhalb eines vorgegebenen Arbeitsbereichs bleibt, und welche den Präzisionsshunt 5 kurzschließt, sobald besagte Spannung einen von zwei symmetrisch zum Spannungsnullpunkt liegenden, den Arbeitsbereich begrenzende Grenzwerten $U_g$, - $U_g$ erreicht.

Die Überspannungsschutzschaltung 7 enthält ein Halbleiterventil 8, bestehend aus zwei antiparallel geschalteten Thyristoren 9a, 9b, das zwischen die beiden Anschlüße derselben gelegt ist. Das Halbleiterventil 8 ist schaltbar und wird von einer parallel zu demselben liegenden Steuerschaltung 10 angesteuert, welche ein symmetrisches Spannungsbegrenzungselement, hier ein Begrenzerdiodenpaar 11 enthält. Zu jeder Seite desselben zweigt ein Steueranschluß zur Ansteuerung eines der Thyristoren 9a, 9b ab. Das Begrenzerdiodenpaar 11 wird von zwei Dioden 12a, 12b flankiert, welche anodenseitig mit den Anschlüßen der Überspannungsbegrenzungsschaltung 7 verbunden sind.

Parallel zum Halbleiterventil 8 und zur Steuerschaltung 10 ist ein rasch ansprechender Überspannungsbegrenzer gelegt, welcher bei schnellen Transienten den Überspannungsschutz bis zum Durchzünden der Thyristoren 9a, 9b übernimmt. Er ist als Varistor 13 realisiert, es könnte aber auch z. B. eine bidirektionale Transzorb® (eingetragene Marke der Firma General Semiconductor, USA) -Diode verwendet sein.

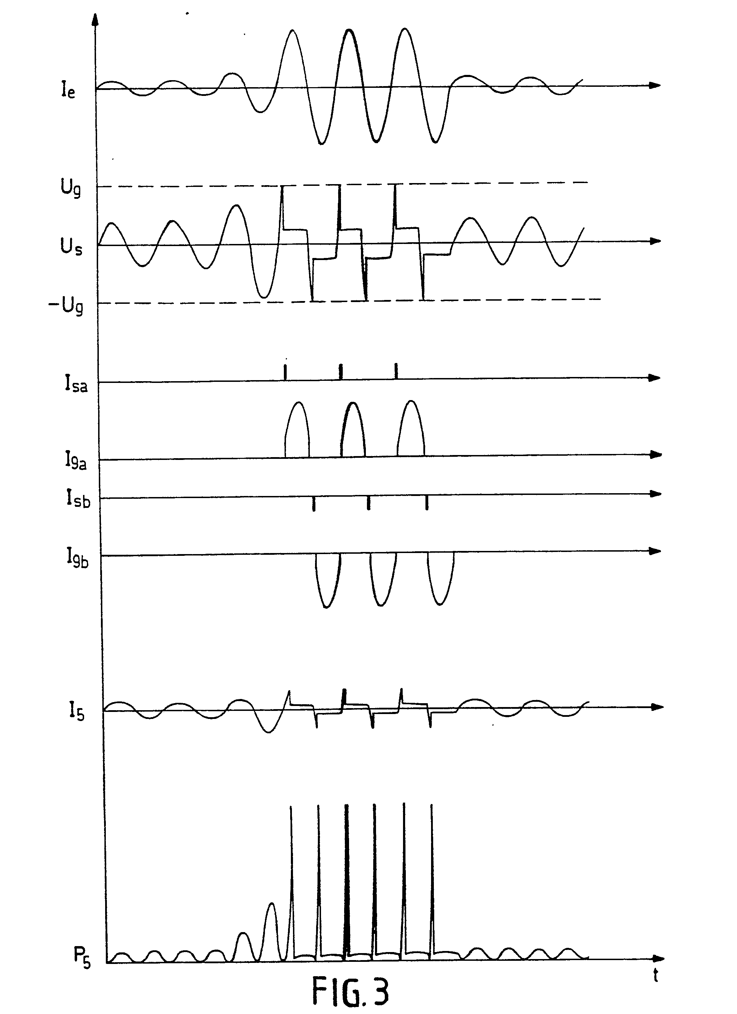

Parallel zur Reihenschaltung aus dem Leistungsshunt 3 und dem Präzisionsshunt 5 liegt eine Reihenschaltung aus einem ersten Brückenwiderstand 14 und einem zweiten Brückenwiderstand 15, welche mit dem Leistungsshunt 3 und dem Präzisionsshunt 5 eine abgeglichene Brückenschaltung bilden. Zur Vermeidung einer Beeinträchtigung der Meßgenauigkeit an den Shunts sind die Brückenwiderstände 14, 15 wesentlich hochohmiger gewählt als jene. Mit dem zwischen dem ersten Brückenwiderstand 14 und dem zweiten Brückenwiderstand 15 liegenden Abgleichpunkt der Brückenschaltung ist der Eingang eines Fensterdiskriminators 16 verbunden, der dort die Spannung daraufhin überwacht, ob sie innerhalb eines sich symmetrisch um den Spannungsnullpunkt erstreckenden Toleranzintervalls liegt. Im Zusammenhang mit Fig. 3 wird nun die Funktion der erfindungsgemäßen Shunt-Anordnung nach Fig. 1 erläutert.

In Fig. 3 ist ein beispielsweiser zeitlicher Verlauf des vom zweiten Anschluß 2 nach Masse fliessenden Eingangsstroms $I_e$ - vom ersten Anschluss 1 über den Leistungsshunt 3 nach Masse fließt ein gleich großer Strom umgekehrt Vorzeichens -, der am Präzisionsshunt 5 eine Spannung $U_5$ erzeugt, welche anfangs die Grenzwerte $U_g$, - $U_g$ nicht erreicht, so daß die Überspannungsschutzschaltung 7 sperrt und die Spannung $U_5$ am Präzisionsshunt 5 dem Eingangsstrom $I_e$ sehr genau proportional ist. Die durch den Leistungsshunt 3, den Präzisionsshunt 5, den ersten Brückenwiderstand 14 und den zweiten Brückenwiderstand 15 gebildete Brückenschaltung ist abgeglichen und das Ausgangssignal des Fensterkomparators ist "0". Ein Überstromstoß läßt die Spannung $U_5$ am Präzisionsshunt 5 so groß werden, daß der Grenzwert $U_g$ erreicht wird.

Das führt zum Ansprechen des symmetrischen Spannungsbegrenzungselements 11, so daß dem Gate des Thyristors 9a vom Anschluß 2 über die Diode 12a ein Steuerstrom $I_{sa}$ zugeführt wird und er durchzündet. Der Thyristor 9a übernimmt nun annähernd bis zum nächsten Stromnulldurchgang mit dem Thyristorstrom $I_{9a}$ den größten Teil des Eingangsstroms $I_e$. Die Spannung $U_5$ am Präzisionsshunt 5 bricht weitgehend zusammen. Entsprechend gering ist dann auch der Strom $I_5$ durch den Präzisionsshunt 5. In völlig analoger Weise wird bei der nächsten Halbwelle der Thyristor 9b gezündet usf. bis die Amplitude des Eingangsstroms $I_e$ wieder so weit gesunken ist, dass die Grenzwerte $U_g$, - $U_g$ durch die am Präzisionsshunt 5 abfallende Spannung $U_5$ nicht mehr erreicht werden.

Es ist natürlich möglich, als Überspannungsschutzschaltung nur einen passiven Überspannungsbegrenzer, z. B. einen Varistor einzusetzen. Dabei muß jedoch, wegen des unscharfen Übergangs zwischen sperrendem und leitendem Zustand, der Arbeitsbereich kleiner gewählt werden als der durch die Grenzwerte $U_g$, - $U_g$ eingegrenzte Bereich. Zudem hat der Einsatz eines Halbleiterventils, welches bei Erreichen einer der Belastungsgrenzen in einen leitenden Zustand übergeht und annähernd bis zum nächsten Stromnulldurchgang in demselben verbleibt, den Vorteil, daß die Leistungsaufnahme $P_5$ des Präzisionsshunts 5 auch und gerade bei grossen Überströmen sehr gering ist. Durch das Kurzschließen des Präzisionsshunts 5 verringert sich außerdem der zwischen dem ersten Anschluß 1 und dem zweiten Anschluß 2 liegende Widerstand. Bei einer Anwendung der erfindungsgemäßen Shunt-Anordnung zur Verarbeitung des Ausgangsstroms eines induktiven Stromwandlers bedeutet das eine Verringerung der Bürde bei hohen Strömen, was zur Folge hat, daß die Sättigung des Primärwandlers erst bei höheren Strömen eintritt als das etwa bei einer Überspannungsschutzschaltung der Fall wäre, welche die Spannung jeweils für einen Teil der Dauer der jeweiligen Halbwelle am Grenzwert $U_g$ bzw. - $U_g$ festhält, wie das etwa bei einem Varistor der Fall wäre.

Die Wahl eines durch eine Steuerschaltung 10 schaltbaren Halbleiterventils 8, insbesondere eines antiparallel geschalteten Paares von Thyristoren 9a, 9b, beruht auf der großen Präzision und der hohen Strombelastbarkeit, die mit einer solchen Anordnung erreichbar sind.

Bei kurzgeschloßenem Präzisionsshunt 5 liegt das Potential des Abgleichpunktes der bei sperrender Überspannungsschutzschaltung 7 vom Leistungsshunt 3, dem Präzisionsshunt 5, dem ersten Brückenwiderstand 14 und dem zweiten Brückenwiderstand 15 gebildeten Brückenschaltung außerhalb des durch den Fensterdiskriminator 16 definierten Toleranzbereichs. Das Ausgangssignal des Fensterkomparators 16 ist "1". Es zeigt das Auftreten von Überströmen an und kann z. B. zur Messbereichsumschaltung verwendet werden.

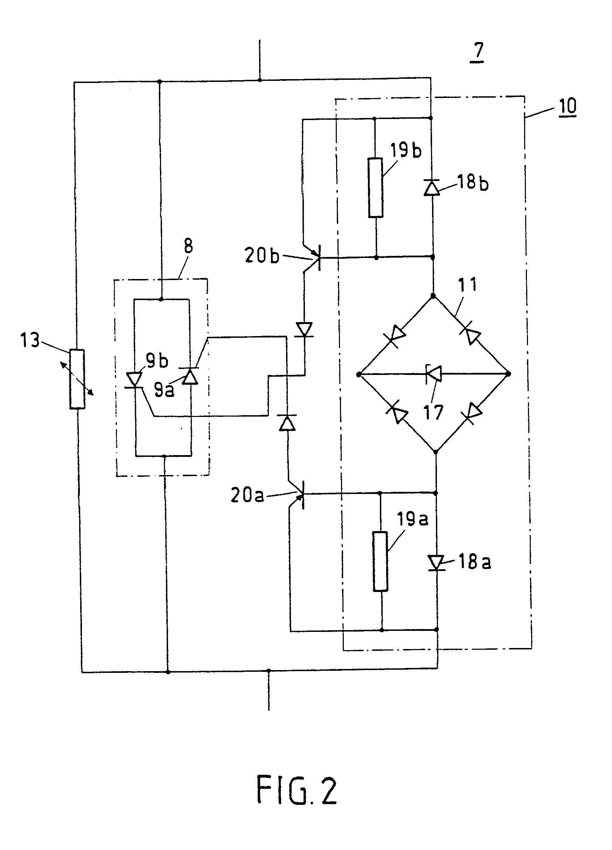

In Fig. 2 ist eine Überspannungsschutzschaltung gemäß einer zweiten Ausführungsform einer erfindungsgemäßen Shunt-Anordnung dargestellt, welche sich von der Überspannungsschutzschaltung gemäß der ersten Ausführungs-Form vor allem durch eine modifizierte Steuerschaltung 10 unterscheidet.

Die Steuerschaltung 10 enthält wiederum ein symmetrisches Spannungsbegrenzungselement 11. Es ist durch einen Vollweggleichrichter, in dessen Ausgang eine Referenzdiode 17 gelegt ist, realisiert. Auf diese Weise wird erreicht, daß die Absolutwerte der beiden Grenzwerte mit grosser Genauigkeit übereinstimmen. Bei Verwendung der erfindungsgemäßen Shunt-Anordnung zur Verarbeitung des Ausgangsstroms eines induktiven Stromwandlers ist aufgrund der der präzise symmetrischen Lage der Grenzwerte eine kumulierende Magnetisierung des Primärwandler-Kerns ausgeschlossen. Zu jeder Seite des Spannungsbegrenzungselements 11, das jeweils über eine Diode 18a, b und einen parallel zu derselben liegenden Widerstand 19a, b mit den Anschlüßen der Überspannungsschutzschaltung 7 verbunden ist, zweigt jeweils ein Steueranschluß ab, der jeweils einem PNP-Transistors 20a, b, welcher einen der Anschlüße der Überspannungsschutzschaltung 7 mit dem Gate eines der Thyristoren 9a, 9b verbindet, ansteuert.

Falls nun die über den Präzisionsshunt 5 abfallende Spannung $U_5$ den Grenzwert $U_g$ erreicht, geht die Referenzdiode 17 in einen leitenden Zustand über, das Potential an der Basis des Transistores 20a fällt unter das Potential des mit dem gerade auf hohem Potential liegenden zweiten elaktrischen Anschluß 2 der Shunt-Anordnung verbundenen Anschlußes der Überspannungsschutzschaltung 7, erschaltet durch und führt dem Gate des Thyristors 9a einen Steuerstrom $I_{sa}$ zu, so daß dieser zündet. Das Verhalten bei Halbwellen umgekehrter Polarität ist ganz analog. Bei beiden Polaritäten wird der Betrag des jeweiligen Grenzwertes $U_g$ bzw. - $U_g$ durch die Durchbruchsspannung der gleichen Referenzdiode 17 bestimmt, was die obenerwähnte präzise Symmetrie bewirkt.

**Patentansprüche**

1. Shunt-Anordnung mit einem Leistungsshunt (3), zu welchem ein zweiter Shunt in Reihe gelegt ist, mit einer Überspannungsschutzschaltung (7), welche parallel zum zweiten Shunt liegt und welche sperrt, solange die über dem zweiten Shunt abfallende Spannung ($U_5$) innerhalb eines den Spannungsnullpunkt enthaltenden Arbeitsbereichs bleibt und welche vor oder bei Erreichen eines von zwei Grenzwerten ($U_g$, - $U_g$), zwischen denen der Arbeitsbereich liegt, ausreichend leitet, um ein Ansteigen besagter Spannung ($U_5$) über die entsprechenden Grenzwerte ($U_g$, - $U_g$) hinaus zu verhindern, dadurch gekennzeichnet,

- daß der zweite Shunt als Präzisionsshunt (5) ausgebildet ist, und
- daß sowohl dem Leistungsshunt (3) als auch dem Präsisionsshunt (5) jeweils eine Verstärkerschaltung (4, 6) nachgeschaltet ist.

2. Shunt-Anordnung nach Anspruch 1, <u>dadurch gekennzeichnet, daß</u> die Überspannungsschutzschaltung (7) ein bidirektionales Halbleiterventil (8) enthält, welches bei Erreichen eines der Grenzwerte ($U_g$, - $U_g$) in einen leitenden Zustand übergeht und annähernd bis zum nächsten Stromnulldurchgang in demselben verbleibt.

3. Shunt-Anordnung nach Anspruch 2, <u>dadurch gekennzeichnet, daß</u> das bidirektionale Halbleiterventil (8) schaltbar ist und daß die Überspannungsschutzschaltung (7) eine parallel zum bidirektionalen Halbleiterventil (8) gelegte Steuerschaltung (10) enthält, welche bei Erreichen eines der beiden Grenzwerte ($U_g$, - $U_g$) jeweils ein Steuersignal an das bidirektionale Halbleiterventil (8) abgibt, welches bewirkt, daß dasselbe in einen leitenden Zustand übergeht.

4. Shunt-Anordnung nach Anspruch 3, <u>dadurch gekennzeichnet, daß</u> das bidirektionale Halbleiterventil (8) zwei antiparallel zueinander geschaltete Thyristoren (9a, 9b) enthält.

5. Shunt-Anordnung nach Anspruch 4, <u>dadurch gekennzeichnet, daß</u> die Steuerschaltung (10) ein symmetrisches Spannungsbegrenzungselement (11) enthält und daß zu jeder Seite des letzteren ein Steueranschluß zur Ansteuerung eines der beiden Thyristoren (9a, 9b) abzweigt.

6. Shunt-Anordnung nach Anspruch 5, <u>dadurch gekennzeichnet, daß</u> das Gate des einen Thyristors (9a) über einen ersten Schalter (Transistor 20a) mit einem Anschluß und das Gate des anderen Thyristors (9b) über einen zweiten Schalter (Transistor 20b) mit dem anderen Anschluß der Überspannungsschutzschaltung (7) verbunden ist und daß jeder Schalter (Transistoren 20a, 20b) über jeweils einen der Steueranschlüße durch die Steuerschaltung (10) schaltbar ist.

7. Shunt-Anordnung nach Anspruch 5 oder 6, <u>dadurch gekennzeichnet, daß</u> das symmetrische Spannungsbegrenzungselement (11) durch ein Begrenzerdiodenpaar realisiert ist.

8. Shunt-Anordnung nach einem der Ansprüche 5 oder 6, <u>dadurch gekennzeichnet, daß</u> das symmetrische Spannungsbegrenzungselement (11) durch einen Vollweggleichrichter, in dessen Ausgang ein Spannungsreferenzelement, vorzugsweise eine Referenzdiode (17), gelegt ist, realisiert ist.

9. Shunt-Anordnung nach einem der Ansprüche 1 bis 8, <u>dadurch gekennzeichnet, daß</u> zur Reihenschaltung aus dem Leistungsshunt (3) und dem Präzisionsshunt (5) eine Reihenschaltung aus einem ersten Widerstand (14) und einem zweiten Widerstand (15) parallel liegt, welche so dimensioniert sind, daß sie mit dem Leistungsshunt (3) und dem Präzisionsshunt (5) eine abgeglichene Brückenschaltung bilden, und daß ein Fensterdiskriminator (16) vorhanden ist, dessen Eingang mit dem zwischen dem ersten Widerstand (14) und dem zweiten Widerstand (15) liegenden Abgleichpunkt der Brückenschaltung verbunden ist.

**Claims**

1. Shunt arrangement comprising a power shunt (3), with which a second shunt is placed in series, an odervoltage protection circuit (7) which lies parallel with the second shunt and which is inhibited for as long as the voltage ($U_5$) dropped across the second shunt remains within an operating lange containing the volltage zero and which conducts, before or when one of two limit values ($U_g$, - $U_g$) is reached between which the operating lange is located, sufficiently to prevent the said voltage ($U_5$) from rising above the corressponding limit values ($U_g$, - $U_g$) characterized in that,

-the second shunt is constructed as a precision shunt (5), and

- both the power shunt (3) and the precision shunt (5) are in each case followed by an amplifier circuit (4, 6).

2. Shunt arrangement according to claim 1, characterized in that the overvoltage protection circuit (7) contains a bidirectional semiconductor rectifier (8) which changes to a conducting state when one of the limit values ($U_g$, - $U_g$) is reached and remains in this state approximately until the next current zero transition.

3. Shunt arrangement according to Claim 2, characterized in that the bidirectional semiconductor rectifier- (8) can be switched and that the overvoltage protection circuit (7) contains a gate trigger circuit (10) which is connected in parallel with the bidirectional semiconductor rectifier (8) and which, if one of the two limit values ($U_g$, - $U_g$) is reached, delivers in each case a triggering signal to the bidirectional semiconductor rectifier (8) which causes the latter to change to a conducting state.

4. Shunt arrangement according to Claim 3, characterized in that the bidirectional semiconductor rectifier (8) contains two antiparallel-connected thyristors (9a, 9b).

5. Shunt arrangement according to Claim 4, characterized in that the control circuit (10) contains a symmetric voltage limiting element (11) and that at each side of the latter one triggering connection for triggering one of the two thyristors (9a, 9b) branches off.

6. Shunt arrangement according to Claim 5, characterized in that the gate of one thyristor (9a) is connected via a first switch (transistor 20a) to one connection and the gate of the other thyristor (9b) is connected via a second switch (transistor 20b) to the other connection of the overvoltage protection circuit (7) and that each switch (transistors 20a, 20b) can be switched by the control circuit (10) via in each case one of the triggering connections.

7. Shunt arrangement according to Claim 5 or 6, characterized in that the symmetric voltage limiting element (11) is implemented by a pair of limiting diodes.

8. Shunt arrangement according to one of Claims 5 or 6, characterized in that the symmetric voltage limiting element (11) is implemented by a fullwave rectifier, the output of which is connected to a voltage reference element, preferably a reference diode (17).

9. Shunt arrangement according to one of Claims 1 to 8, characterized in that the series circuit consisting of the power shunt (3) and the precision shunt (5) is connected in parallel with a series circuit consisting of a first resistor (14) and a second resistor (15) which are dimensioned in such a manner that, together with the power shunt (3) and the precision shunt (5) they form a calibrated bridge circuit, and that a window discriminator (16) is present, the input of which is connected to the calibrating point of the bridge circuit located between the first resistor (14) and the second resistor (15).

**Revendications**

1. Dispositif de shuntage comprenant un shunt de puissance (3) avec lequel un deuxième shunt est monté en série, un circuit de protection contre les surtensions (7) qui est monté en parallèle avec le deuxième shunt et qui est bloquant aussi longtemps que la tension chutante ($U_5$) au passage du deuxième shunt reste dans les limites d'un domaine de travail contenant le point zéro de tension et qui, avant que l'une de deux valeurs limites $U_g$, - $U_g$ entre lesquelles s'étend le domaine de travail soit atteinte ou au moment où cela se produit, est suffisamment conducteur pour empêcher que la dite tension ($U_5$) excède les valeurs limites correspondantes ($U_g$, - $U_g$), caractérisé en ce que
- le deuxième shunt a la forme d'un shunt de précision (5), et
- un circuit amplificateur (4, 6) est chaque fois monté en aval du shunt de puissance (3) et du shunt de précision (5).

2. Dispositif de shuntage suivant la revendication 1, caractérisé en ce que le circuit de protection contre les surtensions (7) contient une valve à semi-conducteurs bidirectionnelle (8) qui passe sur conduction lorsqu'une des valeurs limites ($U_g$, - $U_g$) est atteinte et qui reste dans cet état à peu près jusqu'au passage par zéro suivant.

3. Dispositif de shuntage suivant la revendication 2, caractérisé en ce que la valve à semi-conducteurs bidirectionnelle (8) peut être commutée et le circuit de protection contre les surtensions (7) contient un circuit de commande (10) monté en parallèle avec la valve à semi-conducteurs bidirectionnelle (8) qui, chaque fois qu'une des deux valeurs limites ($U_g$, - $U_g$) est atteinte, fournit à la valve à semi-conducteurs bidirectionnelle (8), un signal de commande qui la fait passer sur conduction.

4. Dispositif de shuntage suivant la revendication 3, caractérisé en ce que la valve à semi-conducteurs bidirectionnelle (8) comprend deux thyristors (9a, 9b) montés en antiparallèle l'un par rapport à l'autre.

5. Dispositif de shuntage suivant la revendication 4, caractérisé en ce que le circuit de commande (10) contient un élément limiteur de tension symétrique (11) et que, de chaque côté de celui-ci, part une connexion de commande pour activer l'un des deux thyristors (9a, 9b).

6. Dispositif de shuntage suivant la revendication 5, caractérisé en ce que la gâchette de l'un des thyristors (9a) est connectée, par l'intermédiaire d'un premier commutateur (transistor 20a), à une des bornes et la gâchette de l'autre thyristor (9b) est connectée, par l'intermédiaire d'un deuxième commutateur (transistor 20b), à l'autre borne du circuit de protection contre les surtensions (7), et chaque commutateur (transistors 20a, 20b) peut être commuté par le circuit de commande (10) chaque fois par l'intermédiaire de l'une des connexions de commande.

7. Dispositif de shuntage suivant la revendication 5 ou 6, caractérisé en ce que l'élément limiteur de tension symétrique (11) est réalisé au moyen d'une paire de diodes de limitation.

8. Dispositif de shuntage suivant la revendication 5 ou 6, caractérisé en ce que l'élément limiteur de tension symétrique (11) est réalisé au moyen d'un redresseur à deux alternances dans la sortie duquel est prévu un élément de référence de tension, qui est de préférence une diode de référence (17).

9. Dispositif de shuntage suivant l'une quelconque des revendications 1 à 8, caractérisé en ce qu'en parallèle au montage en série du shunt de puissance (3) et du shunt de précision (5) est prévu un montage en série d'une première résistance (14) et d'une deuxième résistance (15) qui sont dimensionnées de telle manière qu'elles forment, avec le shunt de puissance (3) et le shunt de précision (5), un circuit en pont équilibré et il est prévu un discriminateur à fenêtre 16 dont l'entrée est connectée au point d'équilibrage du circuit en pont situé entre la première résistance (14) et la deuxième résistance (15).

FIG.1

0 155 627

FIG.2

0 155 627

FIG. 3